# EUROPÄISCHE PATENTSCHRIFT

(11) **EP 2 946 220 B1**
(45) Veröffentlichungstag und Bekanntmachung des Hinweises auf die Patenterteilung: **04.11.2020**
(21) Anmeldenummer: 13798314.4
(22) Anmeldetag: 27.11.2013
(51) Int. Cl.: G01R 31/364, G01R 1/20

(54) **MESSANORDNUNG MIT EINEM MESSWIDERSTAND**
MEASURING ARRANGEMENT WITH A MEASURING RESISTOR
DISPOSITIF DE MESURE DOTÉ D'UNE RÉSISTANCE DE MESURE

(30) Priorität: 16.01.2013 DE 102013200580
(43) Veröffentlichungstag der Anmeldung: 25.11.2015
(73) Patentinhaber: Robert Bosch GmbH, 70442 Stuttgart (DE)
(72) Erfinder: DOLLANSKY, Matthias, 71701 Schwieberdingen (DE); ANSEL, Achim, 70734 Fellbach (DE); PROBA, Markus, 71636 Ludwigsburg (DE); MUELLER, Michael, 71277 Rutesheim (DE)
(86) Internationale Anmeldenummer: PCT/EP2013/074835
(87) Internationale Veröffentlichungsnummer: WO 2014/111188

(56) Entgegenhaltungen:
- DE-A1- 10 136 941
- DE-A1-102004 053 650
- DE-A1-102005 041 881
- US-A1- 2011 006 754

## Beschreibung

Die vorliegende Erfindung betrifft eine Messanordnung mit einem Messwiderstand.

### Stand der Technik

Aus dem Stand der Technik sind Batteriepolklemmenanordnungen mit integrierten Strommessschaltungen zum Erfassen des Stromflusses aus der Batterie bekannt.

So offenbart bspw. die DE 10 2004/046855 B3 eine Batteriepolklemmenanordnung, die eine Polklemme mit einem Befestigungsbereich umfasst. Ein Messwiderstand für einen Batteriesensor ist mittels eines Befestigungselements an dem Befestigungsbereich der Polklemme angebracht. Das Befestigungselement besteht aus einem den Befestigungsbereich passierenden Bolzen und einer den Bolzen umfassenden Isolierhülse.

Aus der DE 10 2004/007851 A1 ist eine als intelligente Anschlussvorrichtung ausgebildete Batteriepolklemmenanordnung bekannt, bei der der Messwiderstand in der Anschlussvorrichtung integriert ist, so dass die beiden Elemente einteilig ausgestaltet sind.

Eine Kraftfahrzeugbordnetzsensorvorrichtung zur Erfassung des Stroms, der Spannung und/oder der Temperatur innerhalb eines Bordnetzes eines Kraftfahrzeugs ist in der Druckschrift EP 1 644 749 B1 beschrieben und umfasst zwei an stromführenden Leitungen innerhalb des Bordnetzes angeschlossene Anschlussstücke, die mit einem Messwiderstand verbunden sind. Dabei weist zumindest ein Anschlussstück eine Schlüsselfläche zum Aufnehmen einer Auswertelektronik auf. Der Messwiderstand ist im Wesentlichen rotationssymetrisch ausgebildet und zwischen den Anschlussstücken angeordnet.

Die Druckschrift EP 1 807 708 B1 beschreibt einen Batteriestromsensor für ein Kraftfahrzeug, der einen in den Batteriestromkreis eingefügten Messsensor und eine mit dem Messsensor verbundene Messschaltungsanordnung umfasst, wobei Teile der Messschaltungsanordnung auf einem Schaltungsträger angeordnet sind, der mit dem Messsensor über federnde Verbindungsmittel positionsfest elektrisch und mechanisch verbunden ist. Aufgrund federnder Eigenschaften der Verbindungsmittel können thermische Längenänderungen des Messsensors in dessen Querrichtung ausgeglichen werden. Aus der US 2011/0006754 A1 ist bereits eine Strommessvorrichtung mit einem Shuntwiderstand bekannt. Der aus Kupfer bestehende Widerstand weist eine C-förmige Struktur auf mit einer dazwischenliegenden Struktur mit verringerter Dicke.

Aus der DE 10 2005 041 881 A1 ist eine Anschlusseinrichtung für eine Batterie bekannt. Die Anschlusseinrichtung umfasst einen Messwiderstand als Teil einer Messeinrichtung für den Batteriestrom. Der Messwiderstand ist im Wesentlichen ringförmig ausgebildet und zwischen der Polklemme und dem Pol angeordnet, so dass der Stromfluss zwischen dem Pol und der Polklemme über den Messwiderstand erfolgt.

Aktuelle Auslegungen von Batteriesensoren haben oft einen ebenen Shunt, der in einer Ebene die Anschlüsse für die Polklemme und den Kabelschuh zur Verfügung stellt. Daraus ergibt sich ein relativ großer Platzbedarf. Die auftretenden Kräfte vom Kabelschuh und der Polklemme befinden sich nicht in einer Achse, so dass entweder die Polklemme oder das eigentliche Elektronikgehäuse zusätzliche Haltefunktionen übernehmen muss.

Der Erfindung liegt die Aufgabe zugrunde, eine platzsparende Messanordnung anzugeben, die die auf sie wirkenden mechanischen Kräfte zuverlässig aufnimmt. Diese Aufgabe wird gelöst durch eine Vorrichtung mit den Merkmalen des unabhängigen Anspruchs.

### Offenbarung der Erfindung

Die erfindungsgemäße Vorrichtung mit den Merkmalen des unabhängigen Anspruchs hat demgegenüber den Vorteil, dass insbesondere durch den Einsatz eines gebogenen Messwiderstands bzw. Shunts (C- oder U-Form) insbesondere aus Kupfer/Manganin/Kupfer oder komplett aus einem Widerstandsmaterial wie Manganin Bauraum eingespart wird. Auch die auftretenden Kräfte zwischen Polklemme und Kabelschuh können innerhalb des Messwiderstands aufgenommen werden. Die U- bzw. C-förmige Form des Messwiderstands ermöglicht zudem die Anordnung von Kabel und Polklemme an den Endabschnitten, während im Bereich des Mittelabschnitt die Potentialabgriffe zur Stromermittlung mit evtl. in diesem Bereich angeordneten Auswerteschaltung erfolgen können. Dadurch stören sich die genannten Komponenten mechanisch nicht.

In einer zweckmäßigen Weiterbildung ist vorgesehen, dass zumindest ein Endabschnitt einen vorzugsweise um 90° gebogenen Abschnitt aufweist. Der Messwiderstand lässt sich so durch übliche Stanz-Biegeprozesse herstellen. Der Mittelabschnitt, der aus Widerstandsmaterial besteht, wird hierbei nicht in Mitleidenschaft gezogen.

In einer zweckmäßigen Weiterbildung ist vorgesehen, dass zumindest ein Endabschnitt zumindest eine Aussparung aufweist, insbesondere zur Aufnahme zumindest eines Anschlusselements. Die Aussparung kann bevorzugt bei beiden Endabschnitten vorgesehen sein. Damit wird in kompakter Bauform an den Stellen der Aussparung(en) die Aufnahme und Kontaktierung der Anschlusselemente möglich. Bevorzugt ist die Aussparung hierzu zumindest teilweise an die Außenkontur des Anschlusselements angepasst.

In einer zweckmäßigen Weiterbildung ist vorgesehen, dass zumindest ein Anschlusselement mit dem ersten Endabschnitt verbunden ist und/oder ein zweites Anschlusselement mit dem zweiten Endabschnitt verbunden ist zum Anschluss an ein Kabel und/oder eine Polklemme. Gerade bei der U- bzw. C-förmigen Bauform des Messwiderstands eignen sich diese Abschnitte zur Kontaktierung zur Batteriestromerfassung, da diese die mechanischen Kräfte, die auf Kabel und/oder Batteriepolklemme wirken, gut aufnehmen. Bevorzugt ist zumindest ein Anschlusselement mit zumindest einem der Endabschnitte verpresst. Dadurch wird die Robustheit der Anordnung weiter erhöht. In einer zweckmäßigen Weiterbildung ist vorgesehen, dass das Anschlusselement zumindest ein Gewinde und/oder eine zylindrische Wandung umfasst. Damit lassen sich Kabel und/oder Polklemme einfach an der Messanordnung befestigen.

In einer zweckmäßigen Weiterbildung ist zumindest eine Isolation, vorzugsweise eine Umspritzung, vorgesehen, die zumindest teilweise zumindest ein Anschlusselement umgibt. Über die Umspritzung wird neben dem Messwiderstand eine zweite Baueinheit gebildet, die leichter mit dem Messwiderstand verbunden werden kann zur Bildung der gesamten Messanordnung. Zudem kann die Isolation zur Aufnahme der mechanischen Kräfte, die auf die Endabschnitte wirken, dienen. Hierzu ist bevorzugt die Isolation, vorzugsweise die Umspritzung zwischen den beiden Endabschnitten und/oder teilweise in der Aussparung angeordnet. In einer zweckmäßigen Weiterbildung ist vorgesehen, dass die Isolation zumindest einen Überstand aufweist, der an der Stirnseite übersteht in Richtung zum Mittelabschnitt. Dadurch wird genaue Montage und auch die mechanische Festigkeit erleichtert, da ein definierter Anschlag der Umspritzung vorgesehen ist und auch Kräfte senkrecht zum Mittelabschnitt aufgenommen werden können. Auch ein Überstand an Ober- und/oder Unterseite in Verbindung mit den Aussparungen der Endabschnitte erleichtert die Montage, da über diese Überstände die Lagefixierung dieser Baueinheit relativ zu dem Messwiderstand erfolgen kann.

In einer zweckmäßigen Weiterbildung ist vorgesehen, dass an dem Messwiderstand zumindest ein Kontaktierelement (Pin) angeordnet ist, insbesondere zwischen dem mittleren Bereich und zumindest einem der Endabschnitte. Dies dient dem Abgriff der beiden Potentiale an den beiden Endabschnitten zur Ermittlung des Spannungsabfalls am Widerstand des Mittelabschnitts zur Bestimmung des fließenden Stroms, insbesondere des Batteriestroms. Die Anordnung in der Nähe des Mittelabschnitts (und nicht an den gegenüber dem Mittelabschnitt um jeweils 90° gebogenen Bereichen der Endabschnitte) ermöglicht einen höheren Freiheitsgrad von Kabelschuhposition bzw. Polklemmenposition (Abgangsrichtung). Diese Position der Kontaktierelemente hindert nicht die Anordnung von Kabel und/oder Polklemme an den o.g. Endabschnitten. In einer zweckmäßigen Weiterbildung ist vorgesehen, dass das Kontaktierelement zentrisch zur Breite des Mittelabschnitts angeordnet ist. Damit wird eine hohe Messgenauigkeit erreicht unabhängig von der Kabelschuhposition und der Polklemmenposition.

In einer zweckmäßigen Weiterbildung ist vorgesehen, dass der Mittelabschnitt und/oder zumindest einer der Endabschnitte aus einem Widerstandsmaterial, insbesondere Manganin, oder aus einem elektrisch leitfähigem Material, insbesondere Kupfer, besteht. Damit lässt sich der Messwiderstand besonders kompakt und robust ausführen und ausgehend von einem bandförmigen Zustand in die gewünschte U- bzw. C-förmige Form bringen.

Weitere Vorteile und Ausgestaltungen der Erfindung ergeben sich aus der Beschreibung der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben.

Kurze Beschreibung der Zeichnung
- Figur 1: zeigt eine erste Ausführungsform eines erfindungsgemäßen Messwiderstands in perspektivischer Darstellung sowie in der Seitenansicht.
- Figur 2: zeigt eine zweite Ausführungsform eines erfindungsgemäßen Messwiderstands mit elektrischer Kontaktierung.
- Figur 3: zeigt eine Messanordnung mit einem Messwiderstand nach Figur 2.
- Figur 4: zeigt eine weitere Messanordnung.

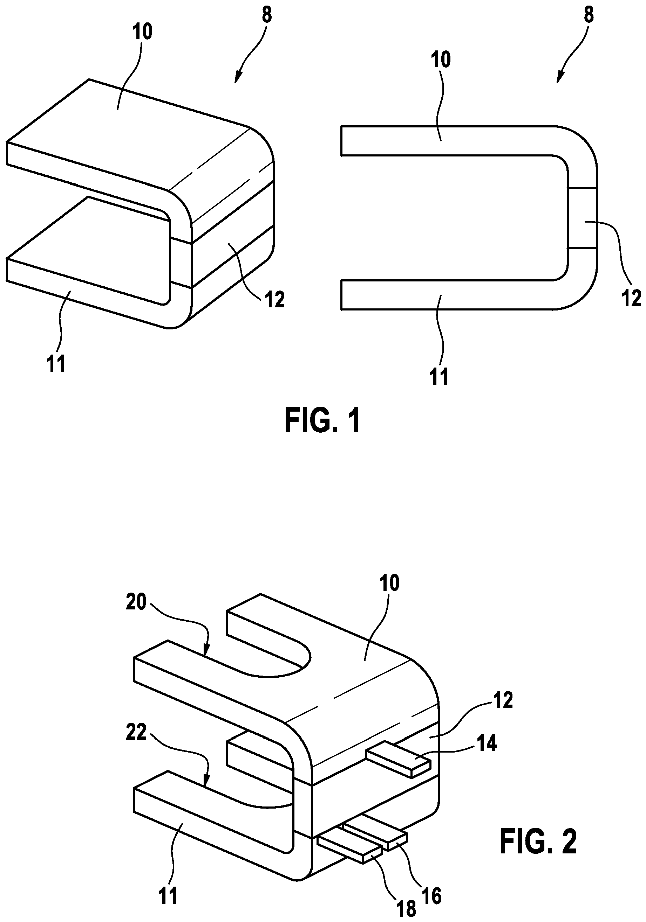

Figur 1 zeigt einen erfindungsgemäßen Messwiderstand 8 (oder auch Messshunt) für eine Batteriepolklemme. Der Messwiderstand 8 ist im Wesentlichen U- bzw. C-förmig bzw. bügelförmig ausgebildet. Der Messwiderstand 8 besteht aus einem ersten Endabschnitt 10, der über einen Mittelabschnitt 12 mit einem zweiten Endabschnitt 11 verbunden ist. Der erste und zweite Endabschnitt 10, 11 besitzen im Wesentlichen dieselbe Geometrie. Die Endabschnitte 10, 11 sind rechteckförmig bzw. flachbandförmig ausgebildet und an dem einen Ende um ca. 90° gebogen hin zu dem Mittelabschnitt 12. An diesen gebogenen oder abgekröpften Abschnitten schließt sich jeweils der Mittelabschnitt 12 an. Die Hauptebenen der Endabschnitte 10, 11 sind im Wesentlichen parallel zueinander.

Der Mittelabschnitt 12 besitzt dieselbe Breite wie die Endabschnitte und ist rechteckförmig ausgebildet. Der Mittelabschnitt 12 besteht aus einem Widerstandsmaterial wie beispielsweise Manganin zur Ermittlung des über den Messwiderstand 8 fließenden Stroms anhand des Spannungsabfalls. Die Endabschnitte 10, 11 sind aus einem elektrisch leitfähigen Material wie beispielsweise Kupfer ausgeführt. Sie dienen der Kontaktierung des Messwiderstands 8 insbesondere mit dem Batteriekabel auf der einen Seite und der Polklemme auf der anderen Seite. Damit dient die Messanordnung der Erfassung des Batteriestroms.

Der U- bzw. C-förmige Messwiderstand 8 wie in der Figur 1 gezeigt wird über einen zu Anfang ebenen Messwiderstand, der über einen oder mehrere Stanz- bzw. Biegeprozesse die letztendliche Form erhält, hergestellt. Die elektrische Verbindung zur Polklemme und zum Kabelschuh kann über verschiedene Prozesse erfolgen (Schrauben, Klemmen, Löten, Schweißen).

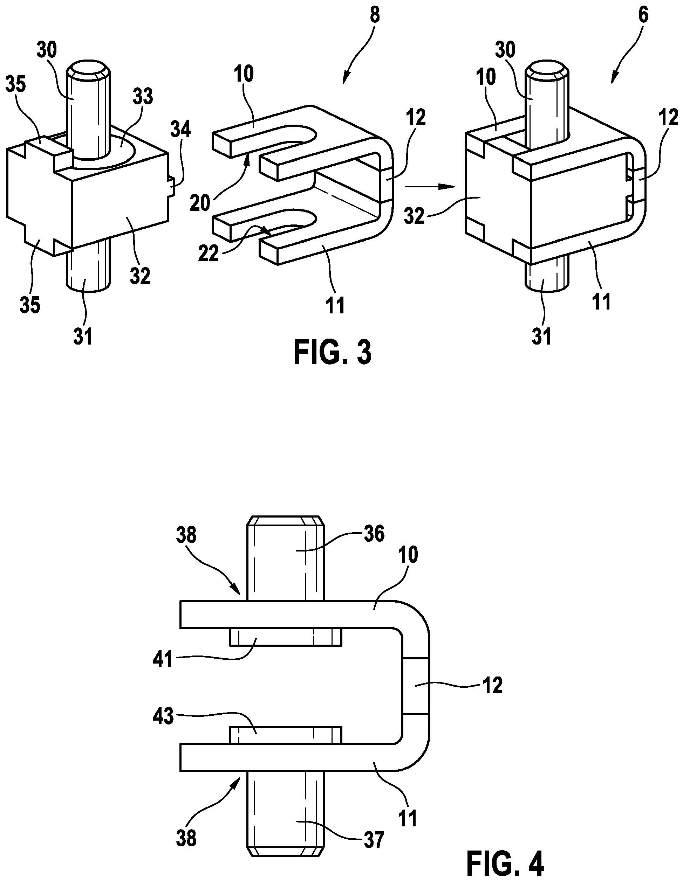

Das Ausführungsbeispiel nach Figur 2 unterscheidet sich von demjenigen nach Figur 1 durch eine erste Ausnehmung 20 im ersten Endabschnitt 10. Auch im zweiten Endabschnitt 11 ist eine zweite Ausnehmung 22 vorgesehen. Die Ausnehmungen 20, 22 erstrecken sich mittig und parallel zu den Seitenkanten von den Enden der Endabschnitte 10, 11 und laufen kreisförmig aus. Damit dienen sie der Aufnahme von in Figur 3 näher gezeigten Anschlusselementen 30, 31. Die beiden Ausnehmungen 20, 22 sind fluchtend zueinander angeordnet. Zum Abgriff des elektrischen Potentials des ersten Endabschnitts 10 ist ein erstes Kontaktierelement 14 vorgesehen. Dieses ist als Pin ausgeführt. Es ist bevorzugt mittig bzw. zentrisch zur Breite des Mittelabschnitts 12 angeordnet und zwar in dem Übergangsbereich zwischen dem Mittelabschnitt 12 und dem ersten Endabschnitt 10. Das erste Kontaktierelement 14 dient dem kabelschuhseitigen Spannungsabgriff. Zwischen dem anderen Ende des Mittelabschnitts 12 und dem zweiten Endabschnitt 11 sind ein zweites Kontaktierelement 16 und ein drittes Kotaktierelement 18 angeordnet. Auch diese Kontaktierelemente 16, 18 sind vorzugsweise als Pins ausgeführt. Das erste Kontaktierelement 14 dient bevorzugt dem polklemmenseitigen Spannungsabgriff.

Die Kontaktierung der Kontaktierelemente 14, 16, 18 (Pins) kann über verschiedene elektrische Kontaktiermöglichkeiten erfolgen (Schweißen, Löten, Einpressen,...). Ein bedeutender Punkt dieser Erfindung ist die Position der Kontaktierelemente 14, 16, 18 Messwiderstand 8. Um eine hohe Messgenauigkeit unabhängig von der Kabelschuhposition und der Polklemmenposition (Abgangsrichtungen) zu erreichen, ist es erforderlich, die Kontaktierelemente 14, 16, 18 (Pins) so weit wie möglich zentrisch zur Breite des Messwiderstands 8 in der Nähe des Widerstandsmaterials (z.B. Manganin) oder auf dem Widerstandsmaterial selbst elektrisch zu kontaktieren.

In Figur 3 sind die Komponenten gezeigt, die nach Montage eine Messanordnung 6 bilden. Der Messwiderstand 8 in der geschlitzten Ausführung entspricht im Wesentlichen derjenigen der Figur 2. Darüber hinaus sind nun zwei Anschlusselemente 30, 31 zentrisch durch eine Isolation 32 bzw. Vorumspritzung mechanisch miteinander verbunden. Die Anschlusselemente 30, 31 sind als Bolzen, bevorzugt als Schraubbolzen ausgebildet. Die zylinderförmigen Bolzen laufen an der zur Isolation 32 orientierten Seite in einem Flansch 33 aus. Die Oberseites des Flansches 33 fluchtet mit der Oberseite der Isolation 32. Die Isolation 32 weist eine im Wesentlichen rechteckförmige Kontur auf, deren Ober- und Unterseite sich zwischen den gebogenen Messwiderstand 8 einschieben lässt. An der Stirnseite in Richtung zum Mittelabschnitt 12 ist ein Überstand 34 vorgesehen, der im mittleren Bereich der Stirnseite etwas übersteht. Frontseitig ist mittig nach oben und unten jeweils ein weiterer Überstand 35 vorgesehen, der im montierten Zustand in die jeweiligen Aussparungen 20, 22 eingreift und nach oben bzw. unten mit den Oberflächen der Endabschnitte 10, 11 fluchtet.

In Figur 3 ist eine Ausführung zu sehen, in der die Kontaktierung der Polklemme und des Kabelschuhs durch eine Schraubverbindung erfolgt. Durch die Vorumspritzung bzw. Isolation 32 der Anschlusselemente 30, 31 bzw. Bolzen mit z.B. einem Thermoplast oder ähnlichem nichtleitenden Material kann eine einfache Montage der Anschlusselemente 30, 31 zum Messwiderstand 8 erfolgen. Zudem werden die auftretenden Schraubkräfte und Zugkräfte, die an den Anschlusselementen 30, 31 auftreten können, durch die Vorumspritzung bzw. Isolation 32 abgefangen. Es kommt hier zu keiner Biegebelastung auf den Messwiderstand 8. Die Bolzenköpfe der Anschlusselemente 30, 31 sind so ausgeführt, dass ein möglichst guter Formschluss zur Umspritzung 32 oder Verguss erfolgt, um die auftretenden Kräfte auf die Umspritzung bzw. Isolation 32 gut ableiten zu können.

Bei dem Ausführungsbeispiel gemäß Figur 4 ist ein oberes Anschlusselement 36 mit dem ersten Endabschnitt 10 durch eine Verpressung 38 verbunden. Ein unteres Anschlusselement 38 ist mit dem zweiten Endabschnitt 11 durch eine Verpressung 38 verbunden. Das obere Anschlusselement 36 läuft an der Unterseite in einem Flansch 41 aus, der mit der Innenseite des ersten Endabschnitts 10 zusammenwirkt. Das untere Anschlusselement 38 läuft an der Oberseite in einem Flansch 43 aus, der mit der Innenseite des zweiten Endabschnitts 11 zusammenwirkt. Hier ist eine mögliche Kontaktierung des Kabelschuhs und der Polklemme mit dem Messwiderstand 8 dargestellt. Die Kontaktierung erfolgt über eine Verschraubung. Die Anschlusselemente 36, 38 können in den Messwiderstand 8 eingepresst, eingeschoben oder während der Verschraubung nur gehalten werden.

Der Mittelabschnitt 12 besteht aus einem für die vorgesehenen Messaufgaben geeigneten Widerstandsmaterial, wie bspw. Manganin. Die beiden Endabschnitte 10, 11 können aus einem elektrisch leitenden Material, wie bspw. Kupfer, bestehen. Der Mittelabschnitt 12 und die beiden Endabschnitte 10, 11 sind durch Löten, Schweißen oder eine andere äquivalente Befestigungsmethode miteinander verbunden. Alternativ könnten auch die Endabschnitte 10, 11 aus einem Widerstandsmaterial bestehen.

Die Erfindung stellt einen einfach und flexibel einsetzbaren Messwiderstand 8 insbesondere für Batteriepolklemmenanwendungen zur Verfügung. Der Messwiderstand 8 ist in jeder Baurichtung verwendbar, der Kabelschuh kann an jeder Seite der Anordnung befestigt werden. Die Anordnung aus Messwiderstand 8 und nicht gezeigter Leiterplatte (der sogenannte elektronische Batteriesensor EBS) kann unabhängig von der Batteriepolklemme vormontiert werden.

Die Kontaktierelemente 14, 16, 18 dienen dem Ankontaktieren beispielsweise einer Leiterplatte. Dort kann eine Schaltung zur Erfassung und Auswertung des Spannungsabfalls am Messwiderstand 8 zur Ermittlung des Batteriestroms vorgesehen werden. Weitere Ermittlungen des Batteriezustands (Ladezustand, Alterung der Batterie oder ähnliches) können ebenfalls implementiert sein. Über eine Schnittstelle kommuniziert der elektronische Batteriesensor mit weiteren Steuergeräten im Fahrzeug. Die Messanordnung 6 kann beispielsweise den Ladezustand der Batterie an ein weiteres Bordnetzsteuergeräts in einem Fahrzeug übermitteln, das abhängig von dem Ladezustand im Start-Stopp-Betrieb entscheidet, ob das Fahrzeug tatsächlich beispielsweise an einer Ampel gestoppt werden kann, ohne das erneute Starten zu gefährden.

Die Erfindung kann vorzugsweise bei Steuergeräten, Sensoren oder sonstigen elektronischen Geräte mit Schnittstellen zu einem Messwiderstand 8 eingesetzt werden. Die beschriebene Messanordnung 6 findet bevorzugten Einsatz als elektronischer Batteriesensor.

## Patentansprüche

1. Messanordnung, umfassend zumindest einen Messwiderstand (8), der durch einen Mittelabschnitt (12) sowie zwei Endabschnitte (10, 11) gebildet ist, wobei der Messwiderstand (8) U- bzw. C-förmig ausgebildet ist, wobei die Endabschnitte (10, 11) jeweils zumindest eine Aussparung (20, 22) aufweisen, **dadurch gekennzeichnet, dass** zumindest ein Anschlusselement (30, 36) mit dem ersten Endabschnitt (10) verbunden ist und ein zweites Anschlusselement (31, 37) mit dem zweiten Endabschnitt (11) verbunden ist zum Anschluss an ein Kabel und/oder eine Polklemme und dass eine Umspritzung zwischen den beiden Endabschnitten (10, 11) und/oder teilweise in der Aussparung (20, 22) angeordnet ist.

2. Messanordnung nach einem der vorhergehenden Ansprüche, **dadurch gekennzeichnet, dass** zumindest ein Endabschnitt (10, 11) einen vorzugsweise um 90° gebogenen Abschnitt aufweist.

3. Messanordnung nach einem der vorhergehenden Ansprüche, **dadurch gekennzeichnet, dass** zumindest ein Anschlusselement (36, 37) mit zumindest einem der Endabschnitte (10, 11) verpresst ist.

4. Messanordnung nach einem der vorhergehenden Ansprüche, umfassend zumindest eine Isolation (32), vorzugsweise eine Umspritzung, die zumindest teilweise zumindest ein Anschlusselement (30, 31) umgibt.

5. Messanordnung nach einem der vorhergehenden Ansprüche, **dadurch gekennzeichnet, dass** die Isolation (32) zumindest einen Überstand (34) aufweist, der an der Stirnseite übersteht in Richtung zum Mittelabschnitt (12).

6. Messanordnung nach einem der voranstehenden Ansprüche, **dadurch gekennzeichnet, dass** an dem Messwiderstand (8) zumindest ein Kontaktierelement (14, 16, 18) angeordnet ist, insbesondere zwischen dem mittleren Bereich (12) und zumindest einem der Endabschnitte (10, 11).

7. Messanordnung nach einem der voranstehenden Ansprüche, **dadurch gekennzeichnet, dass** das Kontaktierelement (14) zentrisch zur Breite des Mittelabschnitts (12) angeordnet ist.

8. Messanordnung nach einem der voranstehenden Ansprüche, **dadurch gekennzeichnet, dass** der Mittelabschnitt (12) und/oder zumindest einer der Endabschnitte (10, 11) aus einem Widerstandsmaterial, insbesondere Manganin, oder aus einem elektrisch leitfähigem Material, insbesondere Kupfer, besteht.

9. Messanordnung nach einem der vorhergehenden Ansprüche, **dadurch gekennzeichnet, dass** das Anschlusselement (30, 31, 36, 37) zumindest ein Gewinde und/oder eine zylindrische Wandung umfasst.

## Claims

1. Measuring arrangement, comprising at least one measuring resistor (8) which is formed by a central portion (12) and two end portions (10, 11), wherein the measuring resistor (8) is of U-shaped or C-shaped design, wherein the end portions (10, 11) each have at least one cutout (20, 22), **characterized in that** at least one connector element (30, 36) is connected to the first end portion (10) and a second connector element (31, 37) is connected to the second end portion (11) for the purposes of connection to a cable and/or a terminal lug, and **in that** an injection-moulded encapsulation is arranged between the two end portions (10, 11) and/or partially in the cutout (20, 22).

2. Measuring arrangement according to any of the preceding claims, **characterized in that** at least one end portion (10, 11) has a portion which is bent preferably through 90°.

3. Measuring arrangement according to any of the preceding claims, **characterized in that** at least one connector element (36, 37) is pressed together with at least one of the end portions (10, 11).

4. Measuring arrangement according to any of the preceding claims, comprising at least one insulator (32), preferably an injection-moulded encapsulation, which at least partially surrounds a connector element (30, 31).

5. Measuring arrangement according to any of the preceding claims, **characterized in that** the insulator (32) has at least one protrusion (34) which protrudes at the end side in the direction of the central portion (12) .

6. Measuring arrangement according to any of the preceding claims, **characterized in that**, on the measuring resistor (8), there is arranged at least one contact element (14, 16, 18), in particular between the central region (12) and at least one of the end portions (10, 11) .

7. Measuring arrangement according to any of the preceding claims, **characterized in that** the contact element (14) is arranged centrally in relation to the width of the central portion (12).

8. Measuring arrangement according to any of the preceding claims, **characterized in that** the central portion (12) and/or at least one of the end portions (10, 11) is composed of a resistance material, in particular Manganin, or of an electrically conductive material, in particular copper.

9. Measuring arrangement according to any of the preceding claims, **characterized in that** the connector element (30, 31, 36, 37) comprises at least one thread and/or one cylindrical wall.

## Revendications

1. Dispositif de mesure comprenant au moins une résistance de mesure (8) qui est formée d'une portion médiane (12) et de deux portions d'extrémité (10, 11), la résistance de mesure (8) étant en forme de U ou de C, les portions d'extrémité (10, 11) comportant chacun au moins un évidement (20, 22), **caractérisé en ce qu'**au moins un élément de raccordement (30, 36) est relié à la première portion d'extrémité (10) et un deuxième élément de raccordement (31, 37) est relié à la deuxième portion d'extrémité (11) en vue du raccordement à un câble et/ou une borne polaire et **en ce qu'**un enrobage est disposé entre les deux portions d'extrémité (10, 11) et/ou partiellement dans l'évidement (20, 22).

2. Dispositif de mesure selon l'une des revendications précédentes, **caractérisé en ce qu'**au moins une portion d'extrémité (10, 11) comporte une portion de préférence pliée à 90°.

3. Dispositif de mesure selon l'une des revendications précédentes, **caractérisé en ce qu'**au moins un élément de raccordement (36, 37) est comprimé avec l'une au moins des portions d'extrémité (10, 11).

4. Dispositif de mesure selon l'une des revendications précédentes, comprenant au moins un isolant (32), de préférence un enrobage, qui entoure au moins partiellement au moins un élément de raccordement (30, 31).

5. Dispositif de mesure selon l'une des revendications précédentes, **caractérisé en ce que** l'isolant (32) comporte au moins une saillie (34) qui s'étend depuis la face frontale en direction de la portion médiane (12).

6. Dispositif de mesure selon l'une des revendications précédentes, **caractérisé en ce qu'**au moins un élément de contact (14, 16, 18) est disposé sur la résistance de mesure (8), notamment entre la portion médiane (12) et au moins une des portions d'extrémité (10, 11).

7. Dispositif de mesure selon l'une des revendications précédentes, **caractérisé en ce que** l'élément de contact (14) est disposé au centre de la largeur de la portion médiane (12).

8. Dispositif de mesure selon l'une des revendications précédentes, **caractérisé en ce que** la portion médiane (12) et/ou l'une au moins des portions d'extrémité (10, 11) comprend un matériau résistant, notamment de la manganine, ou un matériau électriquement conducteur, notamment du cuivre.

9. Dispositif de mesure selon l'une des revendications précédentes, **caractérisé en ce que** l'élément de raccordement (30, 31, 36, 37) comprend au moins un filetage et/ou une paroi cylindrique.
